(19) **Europäisches Patentamt** / **European Patent Office** / **Office européen des brevets**

(11)  **EP 4 154 692 B1**

(12)  # EUROPÄISCHE PATENTSCHRIFT

(45) Veröffentlichungstag und Bekanntmachung des Hinweises auf die Patenterteilung:
**22.05.2024  Patentblatt 2024/21**

(21) Anmeldenummer: **20754656.5**

(22) Anmeldetag: **28.07.2020**

(51) Internationale Patentklassifikation (IPC):
**H05K 13/08** (2006.01)

(52) Gemeinsame Patentklassifikation (CPC):
**H05K 13/085**

(86) Internationale Anmeldenummer:
**PCT/EP2020/071262**

(87) Internationale Veröffentlichungsnummer:
**WO 2022/022811 (03.02.2022 Gazette 2022/05)**

(54) **VERFAHREN UND VORRICHTUNG ZUM BESTÜCKEN VON LEITERPLATTEN MITTELS EINER FESTRÜSTUNG AUF MINDESTENS ZWEI BESTÜCKUNGSLINIEN**

METHOD AND DEVICE FOR POPULATING CIRCUIT BOARDS BY MEANS OF FIXEDLY ASSIGNED COMPONENTS ON AT LEAST TWO ASSEMBLY LINES

PROCÉDÉ ET DISPOSITIF D'ÉQUIPEMENT DE CARTES DE CIRCUIT IMPRIMÉ AU MOYEN DE COMPOSANTS ATTRIBUÉS DE MANIÈRE FIXE SUR AU MOINS DEUX CHAÎNES DE MONTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**29.03.2023  Patentblatt 2023/13**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**

(74) Vertreter: **Siemens Patent Attorneys Postfach 22 16 34 80506 München (DE)**

(56) Entgegenhaltungen:
**EP-A1- 0 478 361    WO-A1-2018/177538**

**Beschreibung**

Die Erfindung betrifft Verfahren und Vorrichtung zum Bestücken von Leiterplatten mittels einer Rüstung auf mindestens zwei Bestückungslinien in einer Fertigungsanlage.

Eine Bestückungslinie in einer Fertigungs- bzw. Produktionsanlage, die gewöhnlicherweise mehrere Bestückungslinien umfasst, ist zur Bestückung einer oder mehrerer Leiterplatten mit einer Anzahl von Bauelemente eingerichtet.

In vielen Werken bzw. Fertigungsanlagen im Bereich der Elektronikproduktion werden zu fertigende Leiterplatten (bzw. Baugruppen) mittelfristig auf die SMT-Bestückungslinien der jeweiligen Werke zugewiesen. Auf Grund von technischen Restriktionen kann nicht jede Leiterplatte auf jeder Bestückungslinie gefertigt bzw. bestückt werden. Die Leiterplatten besitzen auf den Bestückungslinien meist auch unterschiedliche Produktionszeiten. Zudem dürfen die maximalen Produktionszeitkapazitäten der Bestückungslinien nicht überschritten werden.

Dabei lässt sich unterscheiden zwischen einer Variantenrüstungsfertigung und einer Festrüstungsfertigung.

In der Variantenrüstungsfertigung werden für einen kurzen Planungshorizont (ca. 1-5 Tage) die zu fertigenden bzw. zu bestückenden Leiterplatten in Rüstfamilien ("Cluster") aufgeteilt. Eine Rüstfamilie ist dabei eine Menge von Leiterplattentypen, die mit einer vorbestimmten Anzahl von Bauelementtypen auf der Bestückungslinie produzierbar ist. Die Menge der hierfür benötigten Bauelementtypen wird Rüstung genannt und ist üblicherweise in einem Satz von Wechseltischen aufgenommen. Ein Wechseltisch wird üblicherweise in der Vorrüstung zur Produktion mit den passenden Bauelementen der Bauelementypen aufgerüstet und nachher wieder abgerüstet. Mehrere solche Wechseltische bilden eine Wechseltischsatz.

In der Festrüstungsfertigung werden die Rüstungen für die zu fertigenden Leiterplatten auf Wechseltischen längerfristig (ca. 6-12 Monate) fest gerüstet. Bei mehreren Festrüstungen pro Bestückungslinie werden beim Rüstfamilienwechsel die Wechseltische entsprechend getauscht. Das Auf- und Abrüsten von Wechseltischen ist dann in der täglichen Produktion nicht mehr erforderlich.

Häufig werden die Fertigungen auch gemischt betrieben, wobei ein Teil der Leiterplatten in Festrüstungsfertigung und ein anderer in Variantenfertigung auf der gleichen Bestückungslinie produziert werden. Wegen des geringeren Aufwands für Planung, Lagerhaltung, Vorrüstung und Umrüstung wird allgemein angestrebt, den Anteil der Festrüstungsfertigung zu erhöhen und den Anteil der Variantenrüstungsfertigung zu reduzieren.

Die Ziele bei der Produktionsplanung sind z.B.:

**(a)** Der Rüstaufwand an den Bestückungslinien soll möglichst gering sein. Deshalb sollen möglichst viele Leiterplatten mit Festrüstungen gefertigt werden können.

**(b)** Die Anzahl der Rüstfamilien an den Bestückungslinien soll möglichst gering sein, um den zeitlichen Umrüstaufwand zu reduzieren.

**(c)** Die Gesamtproduktionszeit sollte möglichst minimal sein.

Aus WO 2018/177538 A1 ist ein Verfahren zur durchsatzoptimierten Produktion von Leiterplatten auf mindestens zwei Bestückungslinien bekannt, wobei die Leiterplatten in Gruppen aufgeteilt sind, die Cluster genannt werden, wobei ein Cluster jeweils mittels einer Rüstung gefertigt wird, wobei die Rüstung durch an den Bestückungslinien anbringbare Wechseltische realisiert wird.

EP 0 478 361 A1 offenbart eine Bestückungslinie zum Bestücken von Leiterplatten mit Komponenten, wobei die Arbeitsschritte (operations) Maschinen mit unterschiedlichen Kapazitäten zugeordnet werden. Dabei wird ein Algorithmus (Stingy Component Algorithmus oder Greedy Board Algorithmus) angewandt, um eine Komponente j einer Leiterplatte k einem Produktionsprozess i zuzuordnen.

Es gibt aber noch ein weiteres in der Praxis sehr wichtiges Ziel:
Da der Planungshorizont vorliegend eher mittelfristig ist, gibt es Unsicherheiten hinsichtlich der zukünftigen Stückzahlen der Leiterplattentypen. Dies kann zu unerwünscht starken vom Produktionsplan abweichenden realen Auslastungen/Produktionszeiten der Bestückungslinien führen. Insbesondere können manche Bestückungslinien wegen Unterauslastung "leer" stehen, während andere Bestückungslinien überlastet sind und ihre Produktionsaufträge nicht rechtzeitig abarbeiten können.

Wenn mehrere gleichartige Bestückungslinien vorhanden sind, die jeweils mit Festrüstungen betrieben werden, ist es möglich, die Festrüstungen zwischen den Bestückungslinien auszutauschen.

Es ist Aufgabe der vorliegenden Erfindung, ein Verfahren und eine Vorrichtung gegenüber dem oben genannten Stand der Technik insbesondere im industriellen Umfeld noch flexibler zu gestalten, damit eine möglichst gleichmäße Auslastung der Bestückungslinien erreicht werden kann, insbesondere dann, wenn eine der Bestückungslinien möglicherweise ganz oder teilweise ausfallen sollte.

Die Aufgabe wird durch die in den unabhängigen Ansprüchen angegebenen Merkmale gelöst. In den abhängigen Ansprüchen sind vorteilhafte Weiterbildungen der Erfindung dargestellt.

Die Erfindung beansprucht ein Verfahren zum Bestücken einer vorbestimmten Menge von Leiterplatten mittels einer Rüstung auf mindestens zwei Bestückungslinien in einer Fertigungsanlage,

- wobei jede Bestückungslinie ein Transportsystem sowie einen oder mehrere Bestückungsautomaten umfasst, wobei jeder Bestückungsautomat einen oder mehrere Bestückungsköpfe umfasst, die jeweils dazu eingerichtet sind, von einem Wechseltisch Bauelemente aufzunehmen,
- wobei die Rüstung eine Anzahl von Bauelementtypen umfasst, die zur Bestückung einer Anzahl von der Rüstung zugeordneten Leiterplattentypen, die eine Rüstfamilie von Leiterplattentypen bilden, ausreicht,
- wobei eine Festrüstung, die auf Wechseltische eines Wechseltischsatzes fest gerüstet wird und die Vorräte von Bauelementen der Bauelementtypen in Spuren umfassen, während eines Planungshorizonts unverändert bleibt und wiederholt an der Bestückungslinie eingesetzt werden kann;

wobei das Verfahren folgende Schritte umfasst:

- a) Erfassen einer Menge von Leiterplattentypen, die innerhalb des Planungshorizonts in der Fertigungsanlage bestückt werden sollen;
- b) Erfassen einer Menge von Bauelementtypen aller innerhalb des Planungshorizonts zu bestückenden Leiterplattentypen mit deren Platzverbrauch an Spuren des Wechseltischsatzes und Erfassen einer Anzahl Spuren, die in einer Rüstung realisiert durch eine Anzahl von Wechseltischen gemäß dem Fassungsvermögen dieser Wechseltische Platz haben;
- c) Erfassen einer Menge von Festrüstungs-Rüstfamilien pro Bestückungslinie;
- d) Erfassen von an eine Festrüstungs-Rüstfamilie zuordbaren Leiterplattentypen pro Bestückungslinie, deren Leiterplatten an der Bestückungslinie bestückt werden sollen, wobei die Leiterplattentypen jeweils einer Festrüstung auf einer der Bestückungslinien zugewiesen werden;
- e) Erfassen von an eine Rüstfamilienerweiterung zuordbaren Leiterplattentypen pro Festrüstungs-Rüstfamilie, wobei eine Rüstfamilienerweiterung zusammen mit einer zugehörigen Festrüstungs-Rüstfamilie eine Rüstfamilie ergibt, wobei ein Platzverbrauch an Spuren der einer Festrüstungs-Rüstfamilie und der einer Rüstfamilienerweiterung zugeordneten Bauelementtypen kleiner oder gleich der Anzahl Spuren ist, die in der Rüstung realisiert durch eine Anzahl von Wechseltischen gemäß dem Fassungsvermögen dieser Wechseltische Platz haben und wobei es sich bei den an eine zu einer Festrüstungs-Rüstfamilie zugehörigen Rüstfamilienerweiterung zuordbaren Leiterplattentypen um Leiterplattentypen handelt, die einer anderen Bestückungslinie als die Leiterplattentypen der Festrüstungs-Rüstfamilie zugewiesen worden sind,
- f) Bestimmen einer Zuordnung von Leiterplattentypen zu Festrüstungs-Rüstfamilien und Rüstfamilienerweiterungen,
- wobei das Zuordnen derart erfolgt, dass ein Platzverbrauch an Spuren der einer Festrüstungs-Rüstfamilie und der einer Rüstfamilienerweiterung zugeordneten Bauelementtypen kleiner oder gleich der Anzahl Spuren ist, die in der Rüstung realisiert durch eine Anzahl von Wechseltischen gemäß dem Fassungsvermögen dieser Wechseltische Platz haben; und
- wobei das Zuordnen derart erfolgt, dass die Summe der Produktionszeiten der innerhalb des Planungshorizonts zu bestückenden Leiterplatten derjenigen Leiterplattentypen, die der Festrüstungs-Rüstfamilie zugeordnet sind, ein vorbestimmbares Produktionszeitlimit unterschreitet,
- g) Optimieren der bestimmten Zuordnung, so dass die Summe der Produktionszeiten einer vorteilhaften Menge von zusätzlichen Leiterplattentypen an jeder Bestückungslinie maximiert wird;
- und wobei an jeder Bestückungslinie eine vorteilhafte Menge von zusätzlichen Leiterplattentypen unter Verwendung der Rüstfamilienerweiterung geplant ist, und
- h) Rüsten der Spuren mit den Bauelementen, deren Bauelementtypen für die Bestückung der Leiterplatten in den jeweiligen Festrüstungs-Rüstfamilien und Rüstfamilienerweiterung gebraucht werden; und
- i) Bestücken der Leiterplatten der erfassten Leiterplattentypen aus a) auf der Bestückungslinie mittels der Rüstung aus h).

Die Zuordnungsgüte kann zusätzlich auf der Basis einer der folgenden Möglichkeiten bestimmt werden:

a) einer Anzahl von Aufträgen während des Planungshorizonts, wobei jeder Auftrag eine Bestückung einer Anzahl von Leiterplatten eines vorbestimmten Leiterplattentyps der Festrüstungs-Rüstfamilie betrifft und/oder

b) der Summe der innerhalb des Planungshorizonts zu bestückenden Leiterplatten derjenigen Leiterplattentypen, die der Festrüstungs-Rüstfamilie zugeordnet sind.

Somit können auch Leiterplatten von Leiterplattentypen an dieser Bestückungslinie gefertigt bzw. bestückt werden, die an eigentlichen an einer anderen Bestückungslinie gefertigt werden sollten. Somit kann bei Ausfall oder Überlastung der anderen Bestückungslinie eine Art Redundanz bereitgestellt werden. Somit können mit dieser Bestückungslinie zumindest ein Teil der Produktion von der einen oder mehreren anderen Bestückungslinie übernommen werden.

Die vorteilhafte Menge von zusätzlichen Leiterplatten kann wie folgt bestimmt bzw. berechnet werden:

- aus einer maximalen Anzahl von zusätzlichen Leiterplatten, die an dieser Bestückungslinien bestückt werden können, und/oder
- aus einer maximalen Anzahl an Leiterplattentypen, wenn die zusätzlichen Leiterplatten an dieser Bestückungslinie bestückt werden, und/oder
- aus einer maximalen Anzahl an hoch priorisierten Leiterplattentypen, und/oder
- aus einer Häufigkeit des Auftretens eines Leiterplattentyp innerhalb der zusätzlich bestückbaren Leiterplatten, und/oder
- und/oder aus einer pro Zeiteinheit maximal erzielbaren Stückzahl von bestückbaren Leiterplatten in der Fertigungsanlage
- und/oder aus einer Auswahl von Leiterplattentypen mit maximaler Gesamtproduktionszeit, welche aus der unter a) erfassten Menge von Leiterplattentypen ausgewählt werden.

Die Zurüstung von Bauelementtypen auf die freien Spuren kann somit unter den gegebenen Vorgaben optimiert werden.

Das Bestimmen der Zuordnung aus f) und das Optimieren der bestimmten Zuordnung aus g) kann mittels gemischt ganzzahliger linearer Programmierung durchgeführt werden. Durch den Einsatz von exakten mathematischen Optimierungsverfahren lassen sich deutlich bessere Lösungen erzielen als mit in der Praxis möglichen Heuristiken. Für kleine IP-Programme (ganzzahlige lineare Programme) sind Standardsolver verwendbar, z.B. CPLEX, SCIP, Gurobi.

Ein weiterer Aspekt der Erfindung ist eine Vorrichtung in Form einer Steuereinrichtung, die für die Steuerung der Durchführung der Bestückung von Leiterplatten mittels einer Rüstung auf jeder Bestückungslinie in einer Fertigungsanlage ausgestaltet ist.

Die Steuereinrichtung ist geeignet für eine Bestückung einer vorbestimmten Menge von Leiterplatten mittels einer Rüstung auf mindestens zwei Bestückungslinien in einer Fertigungsanlage,

- wobei jede Bestückungslinie ein Transportsystem sowie einen oder mehrere Bestückungsautomaten umfasst, wobei jeder Bestückungsautomat einen oder mehrere Bestückungsköpfe umfasst, die jeweils dazu eingerichtet sind, von einem Wechseltisch Bauelemente aufzunehmen,
- wobei die Rüstung eine Anzahl von Bauelementtypen umfasst, die zur Bestückung einer Anzahl von der Rüstung zugeordneten Leiterplattentypen, die eine Rüstfamilie von Leiterplattentypen bilden, ausreicht,
- wobei eine Festrüstung, die auf Wechseltische eines Wechseltischsatzes fest gerüstet wird und die Vorräte von Bauelementen der Bauelementtypen in Spuren umfassen, während eines Planungshorizonts unverändert bleibt und wiederholt an der Bestückungslinie eingesetzt werden kann;

wobei die Steuereinrichtung dazu ausgelegt ist,

a) eine Menge von Leiterplattentypen zu erfassen, die innerhalb des Planungshorizonts in der Fertigungsanlage bestückt werden sollen;

b) eine Menge von Bauelementtypen aller innerhalb des Planungshorizonts zu bestückenden Leiterplattentypen mit deren Platzverbrauch an Spuren des Wechseltischsatzes zu erfassen und eine Anzahl Spuren, die in einer Rüstung realisiert durch eine Anzahl von Wechseltischen gemäß dem Fassungsvermögen dieser Wechseltische Platz haben, zu erfassen;

c) eine Menge von Festrüstungs-Rüstfamilien pro Bestückungslinie zu erfassen;

d) an eine Festrüstungs-Rüstfamilie zuordbaren Leiterplattentypen pro Bestückungslinie zu erfassen, deren Leiterplatten an der Bestückungslinie bestückt werden sollen, wobei die Leiterplattentypen jeweils einer Festrüstung auf einer der Bestückungslinien zugewiesen werden;

e) an eine Rüstfamilienerweiterung zuordbaren Leiterplattentypen pro Bestückungslinie zu erfassen, wobei eine Rüstfamilienerweiterung zusammen mit einer zugehörigen Festrüstungs-Rüstfamilie eine Rüstfamilie ergibt, wobei ein Platzverbrauch an Spuren der einer Festrüstungs-Rüstfamilie und der einer Rüstfamilienerweiterung zugeordneten Bauelementtypen kleiner oder gleich der Anzahl Spuren ist, die in der Rüstung realisiert durch eine Anzahl von Wechseltischen gemäß dem Fassungsvermögen dieser Wechseltische Platz haben und wobei es sich bei den an eine zu einer Festrüstungs-Rüstfamilie zugehörigen Rüstfamilienerweiterung zuordbaren Leiterplattentypen um Leiterplattentypen handelt, die einer anderen Bestückungslinie als die Leiterplattentypen der Festrüstungs-Rüstfamilie zugewiesen worden sind,

f) eine Zuordnung von Leiterplattentypen zu Festrüstungs-Rüstfamilien und Rüstfamilienerweiterungen zu bestimmen,

- wobei das Zuordnen derart erfolgt, dass ein Platzverbrauch an Spuren der einer Festrüstungs-Rüstfamilie und der einer Rüstfamilienerweiterung zugeordneten Bauelementtypen kleiner oder gleich der Anzahl Spuren ist, die in der Rüstung realisiert durch eine Anzahl von Wechseltischen gemäß dem Fassungsvermögen dieser Wechseltische Platz haben; und
- wobei das Zuordnen derart erfolgt, dass die Summe der Produktionszeiten der innerhalb des Planungshorizonts zu bestückenden Leiterplatten derjenigen Leiterplattentypen, die der Festrüstungs-Rüstfamilie zugeordnet sind, ein vorbestimmbares Produktionszeitlimit unterschreitet,

g) die bestimmte Zuordnung so zu optimieren, bis die Summe der Produktionszeiten einer vorteilhaften Menge von zusätzlichen Leiterplattentype an jeder Bestückungslinie maximiert wird;

- und wobei an jeder Bestückungslinie eine vorteilhafte Menge von zusätzlichen Leiterplatten unter Verwendung der Rüstfamilienerweiterung geplant,

h) und das Rüsten der Spuren mit den Bauelementen, deren Bauelementtypen für die Bestückung der Leiterplatten in den jeweiligen Festrüstungs-Rüstfamilien und Rüstfamilienerweiterung gebraucht werden, zu steuern,

i) und die Bestückung der Leiterplatten der erfassten Leiterplattentypen aus a) auf der Bestückungslinie mittels der Rüstung aus h) durchzuführen.

Die Vorrichtung und Computerprogramm(produkte) können entsprechend des oben beschriebenen Verfahrens bzw. der Weiterbildungen/Ausführungsformen des vorliegenden Verfahrens aus- bzw. weitergebildet sein.

Des Weiteren wird ein Computerprogramm(produkt) umfassend Programm-Code, der von mindestens einem Prozessor ausgeführt werden kann und der bewirkt, dass der mindestens einen Prozessor das erfindungsgemäße Verfahren und dessen Ausführungsformen ausführt. Das Computerprogramm kann auf einem Rechner z.B. in der Cloud, Server und/oder PC ablaufen oder als Computerprogrammprodukt auf einem computerlesbaren Medium gespeichert sein. Dabei bringt das Computerprogramm die Laufzeitumgebung zum Ablauf.

Zusätzlich kann eine Variante des Computerprogramm(produkte)s mit Programmbefehlen zur Konfiguration eines Erstellungsgeräts, beispielsweise ein 3D-Drucker, ein Computersystem oder eine zur Erstellung von Prozessoren und/oder Geräten geeignete Herstellungsmaschine sein.

Die Mittel können Hardware-, Firmware und/oder Softwareeinheiten bzw. -module sein.

Sofern es in der nachfolgenden Beschreibung nicht anders angegeben ist, beziehen sich die Begriffe "durchführen", "berechnen", "rechnergestützt", "rechnen", "feststellen", "generieren", "konfigurieren", "rekonstruieren" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, speicherprogrammierbare Steuerungen (SPS), Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter "rechnergestützt" kann im Zusammenhang mit der Erfindung beispielsweise eine Implementierung des Verfahrens verstanden werden, bei dem insbesondere ein Prozessor mindestens einen Verfahrensschritt des Verfahrens ausführt.

Unter Bereitstellen kann verstanden werden, dass die Applikation und/oder Fähigkeitspakete selbst den oben genannten Mitteln z.B. in Form einer Verarbeitungseinheit bzw. CPU bzw. einer Kontrolleinheit (Control Unit) bereitgestellt wird. Unter Bereitstellen kann ebenso verstanden werden, dass der Verarbeitungseinheit eine Operation bereitgestellt wird, wobei die Operation die bereitgestellte Applikation selbst sein kann und/oder die Fähigkeitspakete zur Steuerung und/oder Ausführung der Konfiguration verwendet.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Dabei zeigt:

Figur 1    ein Bestückungssystem, das in einer Fertigungsanlage eingesetzt werden kann.

Figur 2    schematisch ein Ablaufdiagramm.

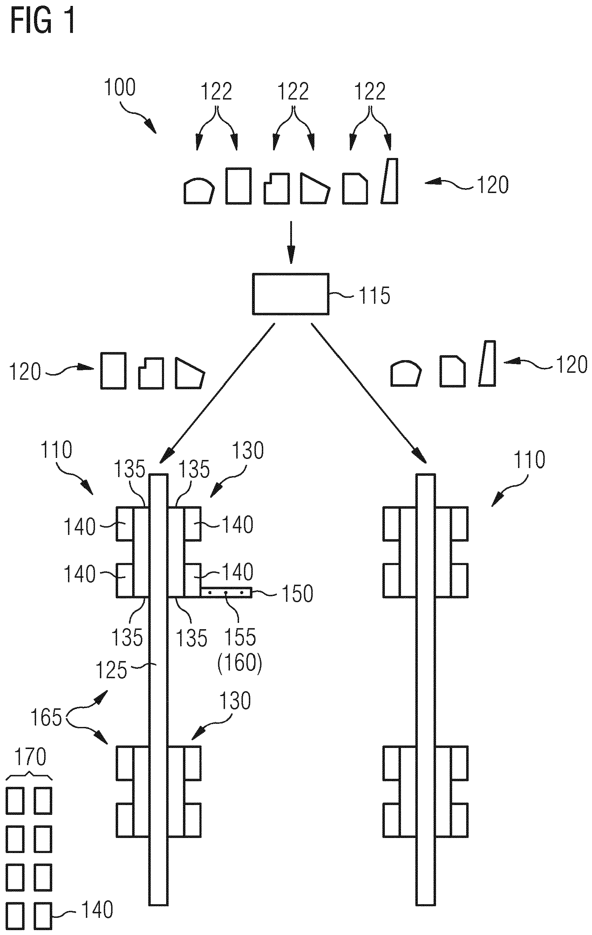

Figur 1 zeigt ein Bestückungssystem 100. Das Bestückungssystem 100 umfasst eine oder mehrere Bestückungslinien 110 und eine Steuereinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Wechseltisch 140 Bauelemente 155 aufzunehmen und an einer vorbestimmten Position auf der Leiterplatte 120 zu positionieren, die sich auf dem Transportsystem 125 befindet.

Während des Bestückungsvorgangs steht die Leiterplatte 120 bezüglich des Bestückungsautomaten 130 üblicherweise still. Die Wechseltische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementetyps 160 bereit. Für die Bauelemente 155 hat die Zuführungseinrichtung 150 ein Fassungsvermögen, das üblicherweise in Spuren ausgedrückt wird. Eine Spur ist üblicherweise 8 mm breit und die Zahl der Spuren jeder Zuführungseinrichtung 150 ist beschränkt, beispielsweise auf 40. Bauelemente 155 des gleichen Bauelementetyps 160 sind üblicherweise bereitgestellt in einem Gurt, auf einem Tablett oder in einer Röhre. Jeder Bauelementetyp 160 erfordert an der Zuführungseinrichtung 150 eine vorbestimmte Anzahl an Spuren, die üblicherweise aneinander angrenzen.

Jede Zuführungseinrichtung 150 kann zur Bereithaltung unterschiedlicher Bauelemente 155 konfiguriert werden und üblicherweise können unterschiedliche Zuführungseinrichtungen 150 an einem Wechseltisch 140 angebracht werden. Wird ein Bauelement 155 eines Bauelementtyps 160 am Bestückungsautomaten 130 benötigt, der nicht in einem der Wechseltische 140 vorhanden ist, so wird üblicherweise nicht einer der angebrachten Wechseltische 140 mit den benötigten Bauelementen 155 versehen, sondern komplett gegen einen anderen, entsprechend bestückten Wechseltisch 140 ausgetauscht. Das Aufrüsten eines einzuwechselnden Wechseltischs 140 mit Bauelementen 155 wird Vorrüstung genannt und kann eine Bearbeitungszeit im Stundenbereich erfordern.

Da ein Wechsel von Wechseltischen 140 an der Bestückungslinie 110 üblicherweise mit einem Produktionsstillstand verbunden ist, wird angestrebt, möglichst selten Wechsel der Wechseltische 140 durchzuführen.

Zur Bestückung einer vorbestimmten Menge von Leiterplatten 120 können Rüstungen gebildet sein, die jeweils Vorräte von Bauelementen 155 von vorbestimmten Bauelementtypen 160 umfassen, wobei jede der Leiterplatten 120 der Menge mit Bauelementen 155 der Rüstung vollständig bestückt werden kann. Eine Rüstung kann realisiert sein durch eine Anzahl von Wechseltischen 140. In der Darstellung von Figur 1 sind eine Festrüstung 165, deren Wechseltische 140 an der Bestückungslinie 110 angebracht sind, und eine Variantenrüstung 170, deren Wechseltische 140 von der Fertigungslinie 110 getrennt sind, gebildet. Es können eine oder mehrere Festrüstungen 165 und eine oder mehrere Variantenrüstungen 170 vorgesehen sein. Ein angestrebter Fall ohne Variantenrüstungen 170 ist möglich.

Die Festrüstung 165 ist dazu eingerichtet, zumindest während eines zeitlichen Planungshorizonts, der beispielsweise ein halbes Jahr oder ein Jahr betragen kann, bezüglich seiner Bauelementtypen 160 unverändert zu bleiben. Es können also im Bedarfsfall zwar Bauelemente 155 an den Wechseltischen 140 der Festrüstung 165 nachgefüllt werden, die Zuordnung von Bauelementtypen 160 zu Spuren der Wechseltische 140 bleibt jedoch unverändert. Sind mehrere Festrüstungen 165 vorgesehen, so können diese innerhalb des Planungshorizonts gegeneinander oder gegen eine der Variantenrüstungen 170 ausgetauscht werden.

Im Beispiel werden an der näher beschriebenen Bestückungslinie 110 nur Festrüstungen eingesetzt.

Die Steuereinrichtung 115 ordnet Leiterplattentypen 122, deren zugeordnete Leiterplatten 120 auf der Bestückungslinie 110 bestückt werden sollen, einer Rüstfamilie zu. Eine Rüstfamilie ist eine Menge von Leiterplattentypen 122, deren Leiterplatten 120 vollständig mit Bauelementen 155 bestückt werden können, die in der zugeordneten Rüstung 165, 170 bereitgestellt sind. Eine Rüstfamilie ist üblicherweise genau einer Rüstung 165, 170 zugeordnet und umgekehrt.

Bestückungslinien, die nur mit Festrüstungen betrieben werden, sind mit einer starren Leiterplatten-Linien-Zuordnung besonders stark von Unterauslastung gefährdet. Bei Überlastung können eventuell Leiterplatten an Bestückungslinien abgegeben werden, an den auch mit Variantenrüstungen gefertigt wird.

Bei mehreren gleichen Bestückungslinien, die jeweils mit mehreren Festrüstungen betrieben werden, besitzt man die Flexibilität, die Festrüstungen unterhalb der Bestückungslinien auszutauschen.

Um die Fertigungs-Flexibilität bei unterschiedlichen Bestückungslinien, die mit Festrüstungen betrieben werden oder bei Bestückungslinien, die mit jeweils einer Festrüstung betrieben werden, zu erhöhen, ist es deshalb günstig, wenn mit der Festrüstung/den Festrüstungen einer Bestückungslinie noch weitere, anderen Bestückungslinien zugewiesene Leiterplattentypen gefertigt werden können. Besonders vorteilhaft ist dies, falls eine Bestückungslinie ganz oder teilweise ausfällt. Dann können evtl. zumindest ein Teil der Leiterplattentypen der ausgefallenen Bestückungslinie auf Bestückungslinien mit Festrüstung zugewiesen werden und deren Leiterplatten dort bestückt werden. Dies funktioniert jedoch nur dann, wenn an der Festrüstungs-Bestückungslinie noch Spuren für die Aufnahme von Bauelementen frei sind und diese Bauelementen den Bauelementtypen, die an der anderen Bestückungslinie eingesetzt sind, entsprechen.

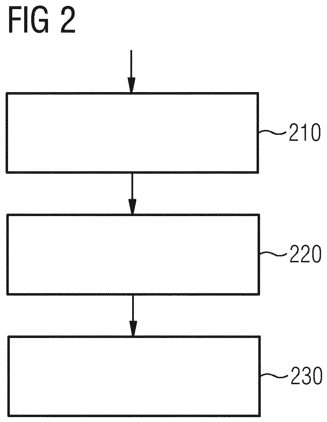

Figur 2 zeigt ein Ablaufdiagramm. Es werden in Schritt 210 erst eine Menge von Leiterplattentypen, die innerhalb eines Planungshorizonts in der Fertigungsanlage bestückt werden sollen erfasst, dann in Schritt 220 Festrüstungen erfasst bzw. gebildet und von an eine Rüstfamilienerweiterung zuordbaren Leiterplattentypen pro Festrüstungs-Rüstfamilie erfasst, deren Leiterplatten an der Bestückungslinie bestückt werden sollen, wobei sich eine Rüstfamilienerweiterung aus einer Rüstfamilie abzüglich der Festrüstungs-Rüstfamilie ergibt.

In Schritt 230 erfolgt eine Leiterplattentyp-Bestückungslinien-Zuordnung, wobei das Zuordnen derart erfolgt, dass ein Platzverbrauch an Spuren der einer Festrüstungs-Rüstfamilie und der einer Rüstfamilienerweiterung zugeordneten Bauelementtypen kleiner oder gleich der Anzahl Spuren ist, die in der Rüstung Platz haben.

Dieser Ansatz kann auf gemischt ganzzahliger linearer Optimierung basieren.

Zur Bildung von Festrüstungen mit fixen und Rüstfamilienerweiterungsanteilen bzw. flexiblen Anteilen wird wie folgt vorgegangen:

Schritt 210:

- a) Erfassen einer Menge von Leiterplattentypen, die innerhalb des Planungshorizonts in der Fertigungsanlage bestückt werden sollen;
- b) Erfassen einer Menge von Bauelementtypen aller innerhalb des Planungshorizonts zu bestückenden Leiterplattentypen mit deren Platzverbrauch an Spuren des Wechseltischsatzes und Erfassen einer Anzahl Spuren, die in einer Rüstung realisiert durch eine Anzahl von Wechseltischen gemäß dem Fassungsvermögen dieser Wechseltische Platz haben;

Schritt 220:

- Erfassen der Festrüstungen je Bestückungslinie. Mit anderen Worten ausgedrückt:
- c) Erfassen einer Menge von Festrüstungs-Rüstfamilien pro Bestückungslinie;
- d) Erfassen von an eine Festrüstungs-Rüstfamilie zuordbaren Leiterplattentypen pro Bestückungslinie, deren Leiterplatten an der Bestückungslinie bestückt werden sollen, wobei die Leiterplattentypen jeweils einer Festrüstung auf einer der Bestückungslinien zugewiesen werden;
- e) Erfassen von an eine Rüstfamilienerweiterung zuordbaren Leiterplattentypen pro Festrüstungs-Rüstfamilie, wobei die Leiterplattentypen jeweils einer Festrüstung auf einer der Bestückungslinien zugewiesen werden;

und in Schritt 230:

- f) Bestimmen einer Zuordnung von Leiterplattentypen zu Festrüstungs-Rüstfamilien und Rüstfamilienerweiterungen,
- wobei das Zuordnen derart erfolgt, dass ein Platzverbrauch an Spuren der einer Festrüstungs-Rüstfamilie und der einer Rüstfamilienerweiterung zugeordneten Bauelementtypen 160 kleiner oder gleich der Anzahl Spuren ist, die in der Rüstung 165 realisiert durch eine Anzahl von Wechseltischen gemäß dem Fassungsvermögen dieser Wechseltische Platz haben; und
- wobei das Zuordnen derart erfolgt, dass die Summe der Produktionszeiten der innerhalb des Planungshorizonts zu bestückenden Leiterplatten 120 derjenigen Leiterplattentypen 122, die der Festrüstungs-Rüstfamilie zugeordnet sind, ein vorbestimmbares Produktionszeitlimit unterschreitet,
- g) Optimieren der bestimmten Zuordnung, so dass die Summe der Produktionszeiten einer vorteilhaften Menge von zusätzlichen Leiterplattentypen an jeder Bestückungslinie maximiert wird;
- und wobei an jeder Bestückungslinie eine vorteilhafte Menge von zusätzlichen Leiterplattentypen unter Verwendung der Rüstfamilienerweiterung geplant sind.

Damit kann das Rüsten der Spuren mit den Bauelementen durchgeführt werden, deren Bauelementtypen für die Bestückung der Leiterplatten in den jeweiligen Festrüstungs-Rüstfamilien und Rüstfamilienerweiterung gebraucht werden.

Für jede Bestückungslinie mit Festrüstungen wird ermittelt, ob und wie sich diese Festrüstungen erweitern lassen, so dass mit ihnen auch Leiterplatten fertigbar sind, deren Fertigung anderen Bestückungslinien zugeordnet ist.

Es werden daher Festrüstungen mit flexiblen Anteilen gebildet. Unter einem flexiblen Anteil einer Festrüstung werden Leiterplatten verstanden, die eigentlich anderen Bestückungslinien zugewiesen aber mit der Festrüstung fertigbar sind. Dieser Ansatz ist in der Regel nur für wenige Festrüstungen praktikabel, jedoch darauf nicht beschränkt. Dieser Ansatz basiert auf gemischt ganzzahliger linearer Optimierung.

Mit dem nachfolgenden MILP (mixed integer linear programing) wird diese Optimierungsaufgabe gelöst mit dem Ziel, die Gesamtheit der flexiblen Anteile der Festrüstungen einer Bestückungslinie *l* möglichst optimal zu gestalten bzw. ggf. zu maximieren.

MILP befasst sich mit der Optimierung linearer Zielfunktionen über eine Menge, die durch lineare Gleichungen und Ungleichungen eingeschränkt ist. Sie ist Grundlage der Lösungsverfahren der (gemischt-) ganzzahligen linearen Optimierung. Ein sogenannter Solver (Löser) ist eine Sammelbezeichnung für spezielle mathematische Computerprogramme, die mathematische Probleme numerisch lösen können. Im Zusammenhang mit MILP (mixed integer linear programing bzw. gemischt ganzzahlige lineare Programmierung) können für IP-Programme (ganzzahlige Optimierungsmodelle) Standardsolver wie z.B. CPLEX, Scip, Gurobi, Xpress verwendet werden.

Im Folgenden wird zunächst für die Bildung von zwei Festrüstungen auf unterschiedlichen Bestückungslinien ein gemischt ganzzahlig lineares Optimierungsmodell beschrieben. Dieses lässt sich für mehr als zwei Festrüstungen erweitern.

Eine Menge von Leiterplattentypen wird auf die Festrüstungen zweier Bestückungslinien aufgeteilt (fixer Anteil). Zudem werden jeder Bestückungslinie noch ein flexibler Anteil von Leiterplattentypen der anderen Bestückungslinie zugeordnet, die auch mit der jeweiligen Festrüstung fertigbar sind.

In der MIP-Formulierung gelten die folgenden Bezeichnungen.

Indices

| | |
|---|---|
| $C$ | Menge der Bauelementtypen |
| $R$ | Menge von Leiterplatten |
| $R_c$ | Menge der Leiterplatten mit Bauelementtyp $c$ |
| $Cl$ | Menge der Festrüstungen/Festrüstungsfamilien $Cl = \{FestrüstungsLinie\ l,\ FestrüstungsLinie\ 2\}$ |

Parameter

| | |
|---|---|
| $Witdth_c$ | Platzverbrauch eines Bauelementtyps $c$ in Spuren |
| $LineCap_{cl}$ | Anzahl der Spuren der Bauelementtypen, die in der Rüstung der Rüstfamilie $cl$ Platz haben |
| $TimeLimit_{r,cl}$ | Produktionszeitschranke für die Festrüstung $cl$ |
| $Time_{r,cl}$ tung | Produktionszeit der Leiterplatte $r$ mit der Festrüs- $cl$ |

Binärvariablen

$assign_{r,cl}$ Variable, die angibt, ob eine Leiterplatte $r$ *(dem fixen Anteil)* der Rüstfamilie $cl$ *zugeornet wird.* (In diesem Fall nimmt sie den Wert 1 an, anderenfalls den Wert 0)

$assignFlex_{r,cl}$ Variable, die angibt, ob eine Leiterplatte $r$ dem flexiblen Anteil der Rüstfamilie $cl$ zugeordnet wird. (In diesem Fall nimmt sie den Wert 1 an, anderenfalls den Wert 0)

$setup_{c,cl}$ Variable, die angibt ob der Bauelementtyp $c$ in der Rüstung der Rüstfamilie $cl$ gerüstet werden muss. (In diesem Fall nimmt sie den Wert 1 an, anderenfalls den Wert 0)

Zielfunktion

$$\text{Maximiere} \sum_{cl \in Cl} \sum_{r \in R} assignFlex_{r,cl} Time_{r,cl}$$

Nebenbedingungen:

(1) Jeder Leiterplattentyp muss genau einer Rüstfamilie fix zugeordnet sein.

$$\sum_{cl \in Cl} \text{assign}_{r,cl} = 1 \qquad r \in R$$

(2) Die Bauelementtypen der Leiterplatten einer Rüstfamilie müssen in eine Rüstung passen.

$$\sum_{c \in C} \text{Width}_c \; setup_{c,cl} \leq LineCap_{cl} \qquad cl \in Cl$$

(3) Alle Bauelementtypen der fixen und flexiblen Leiterplattentypen einer Rüstfamilie müssen in der Rüstung der Rüstfamilie gerüstet werden

$$\sum_{r \in R_c} assign_{r,cl} + \text{assignFlex}_{r,cl} \leq |R_c| setup_{c,cl} \qquad c \in C, cl \in Cl$$

(4) Die Summe der Produktionszeiten der fixen Leiterplattentypen einer Rüstfamilie darf das Produktionszeitlimit nicht überschreiten.

$$\sum_{r \in R} assign_{r,cl} Time_{r,cl} \leq TimeLimit_{cl} \qquad cl \in Cl$$

(5) Eine Leiterplatte darf nicht dem fixen und flexiblen Anteil einer Rüstfamilie zugleich zugeordnet sein.

$$assign_{r,cl} + \text{assignFlex}_{r,cl} \leq 1 \qquad cl \in Cl$$

(6) Variablenrestriktionen

$$\text{assign}_{r,cl} \in \{0,1\} \qquad r \in R, cl \in Cl$$

$$\text{assignFlex}_{r,cl} \in \{0,1\} \qquad r \in R, cl \in Cl$$

$$\text{setup}_{c,cl} \in \{0,1\} \qquad c \in C, cl \in Cl$$

Zudem lassen sich im Modell die folgenden Punkte durch leicht geänderte und zusätzliche Restriktionen berücksichtigen:

- Auf der Bestückungslinie gibt es Bauelement-Wechseltisch-Restriktionen, d.h. Bauelemente dürfen nicht auf alle Wechseltische, sondern nur auf eine Teilmenge
- Maximaler Füllgrad von Rüstungen
- Erweiterung für mehrere Bestückungslinien mit mehreren Festrüstungen
- Leiterplattentypen dürfen höchstens einem flexiblen Festrüstungsanteil zugeordnet werden.

Die vorgenannte Steuerungseinrichtung kann dann mit diesem flexiblen Anteil bzw. der optimalen Zurüstung die Bestückung der Leiterplatten auf der Bestückungslinie steuern.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung des vorstehenden Verfahrens kann anhand von Instruktionen erfolgen, die auf computerlesbaren Speichermedien oder in flüchtigen Computerspeichern (im Folgenden zusammenfassend als computerlesbare Speicher bezeichnet) vorliegen. Der Computerspeicher kann zu einer oder der vorgenannten Steuereinrichtung gehören. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Verfahrensschritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen oder zentralen Speichern abgelegt sein, es ist aber auch möglich, die Instruktionen auf einem entfernten System abzulegen und darauf via Netzwerk zuzugreifen.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Einrichtungen bzw. Einheiten bestehen, die in eine Vorrichtung integriert sein können. Besteht ein Prozessor aus mehreren Einrichtungen, können diese zur parallelen oder sequentiellen Verarbeitung bzw. Ausführung von Instruktionen ausgelegt bzw. konfiguriert sein.

## Patentansprüche

1. Verfahren zum Bestücken einer vorbestimmten Menge von Leiterplatten (120) mittels einer Rüstung (165, 170) auf mindestens zwei Bestückungslinien (110) in einer Fertigungsanlage,

- wobei jede Bestückungslinie (110) ein Transportsystem (125) sowie einen oder mehrere Bestückungsautomaten (130) umfasst, wobei jeder Bestückungsautomat (130) einen oder mehrere Bestückungsköpfe (135) umfasst, die jeweils dazu eingerichtet sind, von einem Wechseltisch (140) Bauelemente (155) aufzunehmen,
- wobei die Rüstung (165, 170) eine Anzahl von Bauelementtypen (160) umfasst, die zur Bestückung einer Anzahl von der Rüstung (165, 170) zugeordneten Leiterplattentypen, die eine Rüstfamilie von Leiterplattentypen (122) bilden, ausreicht,
- wobei eine Festrüstung (165), die auf Wechseltische (140, 145) eines Wechseltischsatzes fest gerüstet wird und die Vorräte von Bauelementen (155) der Bauelementtypen (160) in Spuren umfasst, während eines Planungshorizonts unverändert bleibt und wiederholt an der Bestückungslinie (110) eingesetzt werden kann; wobei das Verfahren folgende Schritte umfasst:

- a) Erfassen einer Menge von Leiterplattentypen, die innerhalb des Planungshorizonts in der Fertigungsanlage bestückt werden sollen;
- b) Erfassen einer Menge von Bauelementtypen aller innerhalb des Planungshorizonts zu bestückenden Leiterplattentypen mit deren Platzverbrauch an Spuren des Wechseltischsatzes und Erfassen einer Anzahl Spuren, die in einer Rüstung (165) realisiert durch eine Anzahl von Wechseltischen gemäß dem Fassungsvermögen dieser Wechseltische Platz haben;
- c) Erfassen einer Menge von Festrüstungs-Rüstfamilien pro Bestückungslinie;
- d) Erfassen von an eine Festrüstungs-Rüstfamilie zuordbaren Leiterplattentypen (122) pro Bestückungslinie, deren Leiterplatten an der Bestückungslinie bestückt werden sollen, wobei die Leiterplattentypen jeweils einer Festrüstung auf einer der Bestückungslinien zugewiesen werden;
- e) Erfassen von an eine Rüstfamilienerweiterung zuordbaren Leiterplattentypen pro Festrüstungs-Rüstfamilie, wobei eine Rüstfamilienerweiterung zusammen mit einer zugehörigen Festrüstungs-Rüstfamilie eine Rüstfamilie ergibt, wobei ein Platzverbrauch an Spuren der einer Festrüstungs-Rüstfamilie und der einer Rüstfamilienerweiterung zugeordneten Bauelementtypen (160) kleiner oder gleich der Anzahl Spuren ist, die in der Rüstung (165) realisiert durch eine Anzahl von Wechseltischen gemäß dem Fassungsvermögen dieser Wechseltische Platz haben und wobei es sich bei den an eine zu einer Festrüstungs-Rüstfamilie zugehörigen Rüstfamilienerweiterung zuordbaren Leiterplattentypen um Leiterplattentypen handelt, die einer anderen Bestückungslinie als die Leiterplattentypen der Festrüstungs-Rüstfamilie zugewiesen worden sind,
- f) Bestimmen einer Zuordnung von Leiterplattentypen zu Festrüstungs-Rüstfamilien und Rüstfamilienerweiterungen,

- wobei das Zuordnen derart erfolgt, dass ein Platzverbrauch an Spuren der einer Festrüstungs-Rüstfamilie und der einer Rüstfamilienerweiterung zugeordneten Bauelementtypen (160) kleiner oder gleich der Anzahl Spuren ist, die in der Rüstung (165) realisiert durch eine Anzahl von Wechseltischen gemäß dem Fassungsvermögen dieser Wechseltische Platz haben; und

- wobei das Zuordnen derart erfolgt, dass die Summe der Produktionszeiten der innerhalb des Planungshorizonts zu bestückenden Leiterplatten (120) derjenigen Leiterplattentypen (122), die der Festrüstungs-Rüstfamilie zugeordnet sind, einen vorbestimmbares Produktionszeitlimit unterschreitet,

- g) Optimieren der bestimmten Zuordnung, so dass die Summe der Produktionszeiten einer vorteilhaften Menge von zusätzlichen Leiterplattentypen an jeder Bestückungslinie maximiert wird;

- und wobei an jeder Bestückungslinie eine vorteilhafte Menge von zusätzlichen Leiterplattentypen unter Verwendung der Rüstfamilienerweiterung geplant ist,

- h) Rüsten der Spuren mit den Bauelementen, deren Bauelementtypen für die Bestückung der Leiterplatten in den jeweiligen Festrüstungs-Rüstfamilien und Rüstfamilienerweiterung gebraucht werden; und

- i) Bestücken der Leiterplatten (120) der erfassten Leiterplattentypen aus a) auf der Bestückungslinie (110) mittels der Rüstung aus h).

2. Verfahren nach dem vorhergehenden Anspruch, **dadurch gekennzeichnet, dass** die Zuordnung zusätzlich auf der Basis einer der folgenden Möglichkeiten bestimmt wird:

a) einer Anzahl von Aufträgen während des Planungshorizonts, wobei jeder Auftrag eine Bestückung einer Anzahl von Leiterplatten (120) eines vorbestimmten Leiterplattentyps (122) der Festrüstungs-Rüstfamilie betrifft und/oder

b) der Summe der innerhalb des Planungshorizonts zu bestückenden Leiterplatten (120) derjenigen Leiterplattentypen (122), die der Festrüstungs-Rüstfamilie zugeordnet sind.

3. Verfahren nach einem der vorhergehenden Ansprüche, **dadurch gekennzeichnet, dass** sich die vorteilhafte Menge von zusätzlichen Leiterplatten aus folgendem ergibt:

- aus einer maximalen Anzahl von zusätzlichen Leiterplatten, die an dieser Bestückungslinien bestückt werden können, und/oder

- aus einer maximalen Anzahl an Leiterplattentypen, wenn die zusätzlichen Leiterplatten an dieser Bestückungslinie bestückt werden, und/oder

- aus einer maximalen Anzahl an hoch priorisierten Leiterplattentypen, und/oder

- aus einer Häufigkeit des Auftretens eines Leiterplattentyp innerhalb der zusätzlich bestückbaren Leiterplatten, und/oder

- und/oder aus einer pro Zeiteinheit maximal erzielbaren Stückzahl von bestückbaren Leiterplatten in der Fertigungsanlage

- und/oder aus einer Auswahl von Leiterplattentypen mit maximaler Gesamtproduktionszeit, welche aus der unter a) erfassten Menge von Leiterplattentypen ausgewählt werden.

4. Verfahren nach einem der vorhergehenden Ansprüche, **dadurch gekennzeichnet, dass** das Bestimmen der Zuordnung aus f) und das Optimieren der bestimmten Zuordnung aus g) mittels gemischt ganzzahliger linearer Programmierung durchgeführt wird.

5. Steuereinrichtung geeignet für eine Bestückung einer vorbestimmten Menge von Leiterplatten (120) mittels einer Rüstung (165, 170) auf mindestens zwei Bestückungslinien (110) in einer Fertigungsanlage,

- wobei jede Bestückungslinie (110) ein Transportsystem (125) sowie einen oder mehrere Bestückungsautomaten (130) umfasst, wobei jeder Bestückungsautomat (130) einen oder mehrere Bestückungsköpfe (135) umfasst, die jeweils dazu eingerichtet sind, von einem Wechseltisch (140) Bauelemente (155) aufzunehmen,

- wobei die Rüstung (165, 170) eine Anzahl von Bauelementtypen (160) umfasst, die zur Bestückung einer Anzahl von der Rüstung (165, 170) zugeordneten Leiterplattentypen, die eine Rüstfamilie von Leiterplattentypen (122) bilden, ausreicht,

- wobei eine Festrüstung (165), die auf Wechseltische (140, 145) eines Wechseltischsatzes fest gerüstet wird und die Vorräte von Bauelementen (155) der Bauelementtypen (160) in Spuren umfassen, während eines Planungshorizonts unverändert bleibt und wiederholt an der Bestückungslinie (110) eingesetzt werden kann; wobei die Steuereinrichtung dazu ausgelegt ist,

a) eine Menge von Leiterplattentypen zu erfassen, die innerhalb des Planungshorizonts in der Fertigungsanlage bestückt werden sollen;

b) eine Menge von Bauelementtypen aller innerhalb des Planungshorizonts zu bestückenden Leiterplattentypen mit deren Platzverbrauch an Spuren des Wechseltischsatzes zu erfassen und eine Anzahl Spuren, die in einer Rüstung (165) realisiert durch eine Anzahl von Wechseltischen gemäß dem Fassungsvermögen dieser Wechseltische Platz haben, zu erfassen;

c) eine Menge von Festrüstungs-Rüstfamilien pro Bestückungslinie zu erfassen;

d) an eine Festrüstungs-Rüstfamilie zuordbaren Leiterplattentypen (122) pro Bestückungslinie zu erfassen, deren Leiterplatten an der Bestückungslinie bestückt werden sollen, wobei die Leiterplattentypen jeweils einer Festrüstung auf einer der Bestückungslinien zugewiesen werden;

e) an eine Rüstfamilienerweiterung zuordbaren Leiterplattentypen pro Bestückungslinie zu erfassen, wobei eine Rüstfamilienerweiterung zusammen mit einer zugehörigen Festrüstungs-Rüstfamilie eine Rüstfamilie ergibt, wobei ein Platzverbrauch an Spuren der einer Festrüstungs-Rüstfamilie und der einer Rüstfamilienerweiterung zugeordneten Bauelementtypen (160) kleiner oder gleich der Anzahl Spuren ist, die in der Rüstung (165) realisiert durch eine Anzahl von Wechseltischenn gemäß dem Fassungsvermögen dieser Wechseltische Platz haben und wobei es sich bei den an eine zu einer Festrüstungs-Rüstfamilie zugehörigen Rüstfamilienerweiterung zuordbaren Leiterplattentypen um Leiterplattentypen handelt, die einer anderen Bestückungslinie als die Leiterplattentypen der Festrüstungs-Rüstfamilie zugewiesen worden sind,

f) eine Zuordnung von Leiterplattentypen zu Festrüstungs-Rüstfamilien und Rüstfamilienerweiterungen zu bestimmen,

- wobei das Zuordnen derart erfolgt, dass ein Platzverbrauch an Spuren der einer Festrüstungs-Rüstfamilie und der einer Rüstfamilienerweiterung zugeordneten Bauelementtypen kleiner oder gleich der Anzahl Spuren ist, die in der Rüstung (165) realisiert durch eine Anzahl von Wechseltischen gemäß dem Fassungsvermögen dieser Wechseltische Platz haben; und

- wobei das Zuordnen derart erfolgt, dass die Summe der Produktionszeiten der innerhalb des Planungshorizonts zu bestückenden Leiterplatten derjenigen Leiterplattentypen, die der Festrüstungs-Rüstfamilie zugeordnet sind, einen vorbestimmbares Produktionszeitlimit unterschreitet,

g) die bestimmte Zuordnung so zu optimieren, bis eine die Summe der Produktionszeiten einer vorteilhaften Menge von zusätzlichen Leiterplattentype an jeder Bestückungslinie maximiert wird;

- und wobei an jeder Bestückungslinie eine vorteilhafte Menge von zusätzlichen Leiterplatten unter Verwendung der Rüstfamilienerweiterung geplant ist,

h) und das Rüsten der Spuren mit den Bauelementen, deren Bauelementtypen für die Bestückung der Leiterplatten in den jeweiligen Festrüstungs-Rüstfamilien und Rüstfamilienerweiterung gebraucht werden, zu steuern,

i) und die Bestückung der Leiterplatten (120) der erfassten Leiterplattentypen aus a) auf der Bestückungslinie (110) mittels der Rüstung aus h) durchzuführen.

## Claims

1. Method for populating a predetermined set of circuit boards (120) by means of a component setup (165, 170) on at least two assembly lines (110) in a manufacturing facility,

- wherein each assembly line (110) comprises a transport system (125) and one or more populating machines (130), wherein each populating machine (130) comprises one or more populating heads (135), which are each configured to pick up components (155) from a shuttle table (140),

- wherein the component setup (165, 170) comprises a number of component types (160), which is sufficient for populating a number of circuit board types assigned to the component setup (165, 170), which form a component cluster of circuit board types (122),

- wherein a fixed component setup (165), which is fixedly set up on shuttle tables (140, 145) of a shuttle table set and comprises reserves of components (155) of the component types (160) in lines, remains unchanged during a planning horizon and can be used repeatedly on the assembly line (110);

wherein the method comprises the following steps:

- a) acquiring a set of circuit board types which are to be populated within the planning horizon in the manufacturing facility;

- b) acquiring a set of component types of all circuit board types to be populated within the planning horizon with their space requirement on lines of the shuttle table set and acquiring a number of lines which have space in a component setup (165) implemented by a number of shuttle tables according to the capacity of these shuttle tables;

- c) acquiring a set of fixed component setup component clusters per assembly line;

- d) acquiring circuit board types (122) assignable to a fixed component setup component cluster per assembly line, the circuit boards of which are to be populated on the assembly line, wherein the circuit board types are each assigned to a fixed component setup on one of the assembly lines;

- e) acquiring circuit board types assignable to a component cluster expansion per fixed component setup component cluster, wherein a component cluster expansion together with an associated fixed component setup component cluster results in a component cluster, wherein a space requirement of lines of the component types (160) assigned to a fixed component setup component cluster and those assigned to a component cluster expansion is less than or equal to the number of lines which have space in the component setup (165) implemented by a number of shuttle tables according to the capacity of these shuttle tables, and wherein the circuit board types assignable to a component cluster expansion associated with a fixed component setup component cluster are circuit board types which have been assigned to a different assembly line than the circuit board types of the fixed component setup component cluster,

- f) determining an assignment of circuit board types to fixed component setup component clusters and component cluster expansions,

- wherein the assignment takes place in such a way that a space requirement on lines of the component types (160) assigned to a fixed component setup component cluster and those assigned to a component cluster expansion is less than or equal to the number of lines which have space in the component setup (165) implemented by a number of shuttle tables according to the capacity of these shuttle tables; and

- wherein the assignment takes place in such a way that the sum of the production times of the circuit boards (120) to be populated within the planning horizon of those circuit board types (122) which are assigned to the fixed component setup component cluster falls below a predeterminable production time limit,

- g) optimizing the determined assignment so that the sum of the production times of an advantageous set of additional circuit board types on each assembly line is maximized;

- and wherein an advantageous set of additional circuit board types is planned on each assembly line using the component cluster expansion,

- h) setting up the lines with the components, the component types of which are used for populating the circuit boards in the respective fixed component setup component clusters and component cluster expansion; and

- i) populating the circuit boards (120) of the acquired circuit board types from a) on the assembly line (110) by means of the component setup from h).

2. Method according to the preceding claim, **characterized in that**
the assignment is additionally determined on the basis of one of the following possibilities:

a) a number of orders during the planning horizon, wherein each order relates to populating a number of circuit boards (120) of a predetermined circuit board type (122) of the fixed component setup component cluster and/or
b) the sum of the circuit boards (120) to be populated within the planning horizon of those circuit board types (122) which are assigned to the fixed component setup component cluster.

3. Method according to either of the preceding claims, **characterized in that** the advantageous set of additional circuit boards results from the following:

- from a maximum number of additional circuit boards which can be populated on these assembly lines, and/or
- from a maximum number of circuit board types, if the additional circuit boards are populated on this assembly line, and/or
- from a maximum number of high-priority circuit board types, and/or
- from a frequency of the occurrence of one circuit board type within the circuit boards that can be additionally populated, and/or
- from a maximum achievable piece count per unit of time of circuit boards that can be populated in the manufacturing facility,
- and/or from a selection of circuit board types having maximum total production time which are selected from the set of circuit board types acquired under a).

4. Method according to one of the preceding claims, **characterized in that** the determination of the assignment from f) and the optimization of the determined assignment from g) are carried out by means of mixed integer linear programming.

5. Control device suitable for populating a predetermined set of circuit boards (120) by means of a component setup (165, 170) on at least two assembly lines (110) in a manufacturing facility,

- wherein each assembly line (110) comprises a transport system (125) and one or more populating machines (130), wherein each populating machine (130) comprises one or more populating heads (135), which are each configured to pick up components (155) from a shuttle table (140),
- wherein the component setup (165, 170) comprises a number of component types (160), which is sufficient for populating a number of circuit board types assigned to the component setup (165, 170), which form a component cluster of circuit board types (122),
- wherein a fixed component setup (165), which is fixedly set up on shuttle tables (140, 145) of a shuttle table set and comprises reserves of components (155) of the component types (160) in lines, remains unchanged during a planning horizon and can be used repeatedly on the assembly line (110);

wherein the control device is designed to

a) acquire a set of circuit board types which are to be populated within the planning horizon in the manufacturing facility;
b) acquire a set of component types of all circuit board types to be populated within the planning horizon with their space requirement on lines of the shuttle table set and acquire a number of lines which have space in a component setup (165) implemented by a number of shuttle tables according to the capacity of these shuttle tables;
c) acquire a set of fixed component setup component clusters per assembly line;
d) acquire circuit board types (122) assignable to a fixed component setup component cluster per assembly line, the circuit boards of which are to be populated on the assembly line, wherein the circuit board types are each assigned to a fixed component setup on one of the assembly lines;
e) acquire circuit board types assignable to a component cluster expansion per assembly line, wherein a component cluster expansion together with an associated fixed component setup component cluster results in a component cluster, wherein a space requirement of lines of the component types (160) assigned to a fixed component setup component cluster and those assigned to a component cluster expansion is less than or equal to the number of lines which have space in the component setup (165) implemented by a number of shuttle tables according to the capacity of these shuttle tables, and wherein the circuit board types assignable to a component cluster expansion associated with a fixed component setup component cluster are circuit board types which have been assigned to a different assembly line than the circuit board types of the fixed component setup component cluster,
f) determine an assignment of circuit board types to fixed component setup component clusters and component cluster expansions,

- wherein the assignment takes place in such a way that a space requirement on lines of the component types assigned to a fixed component setup component cluster and those assigned to a component cluster expansion is less than or equal to the number of lines which have space in the component setup (165) implemented by a number of shuttle tables according to the capacity of these shuttle tables; and
- wherein the assignment takes place in such a way that the sum of the production times of the circuit boards to be populated within the planning horizon of those circuit board types which are assigned to the fixed component setup component cluster falls below a predeterminable production time limit,

g) optimize the determined assignment until a sum of the production times of an advantageous set of additional circuit board types on each assembly line is maximized;

- and wherein an advantageous set of additional circuit boards is planned on each assembly line using the component cluster expansion,

h) and control the setting up of the lines with the components, the component types of which are used for populating the circuit boards in the respective fixed component setup component clusters and component cluster expansion,

i) and carry out the population of the circuit boards (120) of the acquired circuit board types from a) on the assembly line (110) by means of the component setup from h).

**Revendications**

1. Procédé d'équipement d'une quantité prédéterminée de cartes de circuit imprimées (120) au moyen d'un équipement (165, 170) sur au moins deux chaînes de montage (110) dans une installation de fabrication,

   - dans lequel chaque chaîne de montage (110) comprend un système de transport (125) ainsi qu'un ou plusieurs automates de montage (130), dans lequel chaque automate de montage (130) comprend une ou plusieurs têtes de montage (135) qui sont respectivement conçues pour recevoir des composants (155) d'une table alternante (140),
   - dans lequel l'équipement (165, 170) comprend un nombre de types de composants (160) qui suffit pour équiper un nombre de types de cartes de circuit imprimées attribués à l'équipement (165, 170) qui forment une famille d'équipement de cartes de circuit imprimées (122) ;
   - dans lequel un équipement fixe (165) qui est monté fixement sur des tables alternantes (140, 145) d'un jeu de tables alternantes et comprend les réserves de composants (155) des types de composants (160) dans des voies, reste inchangé pendant un horizon de planification et peut être appliqué de manière répétée sur la chaîne de montage (110) ;

   dans lequel le procédé comprend les étapes suivantes :

   - a) détection d'une quantité de types de cartes de circuit imprimées qui doivent être équipés dans l'installation de fabrication dans un horizon de planification ;
   - b) détection d'une quantité de types de composants de tous les types de cartes de circuit imprimées à équiper dans l'horizon de planification avec leur encombrement de voies du jeu de tables alternantes et détection d'un nombre de voies qui ont de la place dans un équipement (165), réalisé par un nombre de tables alternantes selon la capacité de ces tables alternantes ;
   - c) détection d'une quantité de familles d'équipement d'équipements fixes par chaîne de montage ;
   - d) détection de types de cartes de circuit imprimées (122) par chaîne de montage pouvant être attribués à une famille d'équipement d'équipements fixes, dont les cartes de circuit imprimées doivent être équipées sur la chaîne de montage, dans lequel les types de cartes de circuit imprimées sont attribués respectivement à un équipement fixe sur une des chaînes de montage ;
   - e) détection de types de carte imprimée pouvant être attribués à un élargissement de famille d'équipement par famille d'équipement d'équipements fixes, dans lequel un élargissement de famille d'équipement donne, conjointement avec une famille d'équipement d'équipements fixes lui appartenant, une famille d'équipement, dans lequel un encombrement de voies des types de composant (160) attribués à une famille d'équipement d'équipements fixes et des types de composants attribués à un élargissement de famille d'équipement est inférieur ou égal au nombre de voies qui ont de la place dans un équipement (165), réalisé par un nombre de tables alternantes selon la capacité de ces tables alternantes et dans lequel les types de cartes de circuit imprimées pouvant être attribués à un élargissement de famille d'équipement appartenant à une famille d'équipement d'équipements fixes sont des types de cartes de circuit imprimées qui ont été attribués à une autre chaîne de montage que les types de cartes de circuit imprimées de la famille d'équipement d'équipements fixes,
   - f) détermination d'une attribution de types de cartes de circuit imprimées à des familles d'équipement d'équipements fixes et des élargissements de famille d'équipement,
   - dans lequel l'attribution est effectuée de telle façon qu'un encombrement de voies des types de composant (160) attribués à une famille d'équipement d'équipements fixes et des types de composants attribués à un élargissement de famille d'équipement est inférieur ou égal au nombre de voies qui ont de la place dans un équipement (165), réalisé par un nombre de tables alternantes selon la capacité de ces tables alternantes ; et

   dans lequel l'attribution est effectuée de telle façon que la somme des temps de production des cartes de circuit imprimées (120) à équiper dans l'horizon de planification est en-deçà d'une limite de temps de production pouvant être prédéterminée des types de cartes de circuit imprimées (122) qui sont attribués à la famille d'équipement d'équipements fixes,
   g) optimisation de l'attribution déterminée de sorte que la somme des temps de production d'une quantité avantageuse de types de cartes de circuit imprimées supplémentaires soit maximisée sur chaque chaîne de montage ;

- et dans lequel sur chaque chaîne de montage, une quantité avantageuse de types de cartes de circuit imprimées supplémentaires est planifiée en utilisant l'élargissement de famille d'équipement,
- h) équipement des voies avec les composants dont les types de composant sont employés pour équiper les cartes de circuit imprimées dans les familles d'équipement d'équipements fixes et l'élargissement de famille d'équipement respectifs ; et
- i) équipement des cartes de circuit imprimées (120) des types de cartes de circuit imprimées détectés de a) sur la chaîne de production (110) au moyen de l'équipement de h).

2. Procédé selon la revendication précédente, **caractérisé en ce que**
l'attribution est en plus déterminée en se basant sur une des possibilités suivantes :

a) un nombre de commandes pendant l'horizon de planification, dans lequel chaque commande concerne un équipement d'un nombre de cartes de circuit imprimées (120) d'un type de carte de circuit imprimée (122) prédéterminé de la famille d'équipement d'équipements fixes et/ou
b) la somme des cartes de circuit imprimées à équiper dans l'horizon de planification des types de cartes de circuit imprimées (122) qui sont attribués à la famille d'équipement d'équipements fixes.

3. Procédé selon l'une des revendications précédentes, **caractérisé en ce que** la quantité avantageuse de cartes de circuit imprimées supplémentaires résulte de ce qui suit :

- d'un nombre maximal de cartes de circuit imprimées supplémentaires qui peuvent être équipées sur ces chaînes de montage, et/ou
- d'un nombre maximal de types de cartes de circuit imprimées lorsque les cartes de circuit imprimées supplémentaires sont équipées sur cette chaîne de montage, et/ou
- d'un nombre maximal de types de cartes de circuit imprimées priorisés comme élevé, et/ou
- d'une fréquence de la survenue d'un type de carte de circuit imprimée au sein des cartes de circuit imprimées supplémentaires pouvant être équipées, et/ou
- et/ou d'un nombre d'exemplaires maximal pouvant être atteint par unité temporelle de cartes de circuit imprimées pouvant être équipées, dans l'installation de fabrication,
- et/ou d'un nombre de types de cartes de circuit imprimées avec un temps de production global maximal qui sont sélectionnés parmi la quantité de types de cartes de circuit imprimées détectée en a).

4. Procédé selon l'une des revendications précédentes, **caractérisé en ce que** la détermination de l'attribution de f) et l'optimisation de l'attribution déterminée de g) sont exécutées par programmation linéaire mixte en nombres entiers.

5. Dispositif de commande approprié pour équiper une quantité prédéterminée de cartes de circuit imprimées (120) au moyen d'un équipement (165, 170) sur au moins deux chaînes de montage (110) dans une installation de fabrication,

- dans lequel chaque chaîne de montage (110) comprend un système de transport (125) ainsi qu'un ou plusieurs automates de montage (130), dans lequel chaque automate de montage (130) comprend une ou plusieurs têtes de montage (135) qui sont respectivement conçues pour recevoir des composants (155) d'une table alternante (140),
- dans lequel l'équipement (165, 170) comprend un nombre de types de composants (160) qui suffit pour équiper un nombre de types de cartes de circuit imprimées attribués à l'équipement (165, 170) qui forment une famille d'équipement de cartes de circuit imprimées (122) ;
- dans lequel un équipement fixe (165) qui est monté fixement sur des tables alternantes (140, 145) d'un jeu de tables alternantes et comprend les réserves de composants (155) des types de composants (160) dans des voies, reste inchangé pendant un horizon de planification et peut être appliqué de manière répétée sur la chaîne de montage (110) ;

dans lequel le dispositif de commande est conçu pour :

- a) détecter une quantité de types de cartes de circuit imprimées qui doivent être équipés dans l'installation de fabrication dans un horizon de planification ;

- b) détecter une quantité de types de composants de tous les types de cartes de circuit imprimées à équiper dans l'horizon de planification avec leur encombrement de voies du jeu de tables alternantes et de détecter un nombre de voies qui ont de la place dans un équipement (165), réalisé par un nombre de tables alternantes selon la capacité de ces tables alternantes ;

- c) de détecter une quantité de familles d'équipement d'équipements fixes par chaîne de montage ;

- d) de détecter des types de cartes de circuit imprimées (122) par chaîne de montage pouvant être attribués à une famille d'équipement d'équipements fixes, dont les cartes de circuit imprimées doivent être équipées sur la chaîne de montage, dans lequel les types de cartes de circuit imprimées sont attribués respectivement à un équipement fixe sur une des chaînes de montage ;

- e) de détecter des types de carte imprimée pouvant être attribués à un élargissement de famille d'équipement par famille d'équipement d'équipements fixes, dans lequel un élargissement de famille d'équipement donne, conjointement avec une famille d'équipement d'équipements fixes lui appartenant, une famille d'équipement, dans lequel un encombrement de voies des types de composant (160) attribués à une famille d'équipement d'équipements fixes et des types de composants attribués à un élargissement de famille d'équipement est inférieur ou égal au nombre de voies qui ont de la place dans l'équipement (165), réalisé par un nombre de tables alternantes selon la capacité de ces tables alternantes

et dans lequel les types de cartes de circuit imprimées pouvant être attribués à un élargissement de famille d'équipement appartenant à une famille d'équipement d'équipements fixes sont des types de cartes de circuit imprimées qui ont été attribués à une autre chaîne de montage que les types de cartes de circuit imprimées de la famille d'équipement d'équipements fixes,

- f) de déterminer une attribution de types de cartes de circuit imprimées à des familles d'équipement d'équipements fixes et des élargissements de famille d'équipement,

- dans lequel l'attribution est effectuée de telle façon qu'un encombrement de voies des types de composant attribués à une famille d'équipement d'équipements fixes et des types de composants attribués à un élargissement de famille d'équipement est inférieur ou égal au nombre de voies qui ont de la place dans l'équipement (165), réalisé par un nombre de tables alternantes selon la capacité de ces tables alternantes ; et

dans lequel l'attribution est effectuée de telle façon que la somme des temps de production des cartes de circuit imprimées à équiper dans l'horizon de planification est en-deçà d'une limite de temps de production pouvant être prédéterminée des types de cartes de circuit imprimées qui sont attribués à la famille d'équipement d'équipements fixes,

g) optimiser l'attribution déterminée jusqu'à ce que la somme des temps de production d'une quantité avantageuse de types de cartes de circuit imprimées supplémentaires soit maximisée sur chaque chaîne de montage ;

- et dans lequel sur chaque chaîne de montage, une quantité avantageuse de types de cartes de circuit imprimées supplémentaires est planifiée en utilisant l'élargissement de famille d'équipement,

- h) et de commander l'équipement des voies avec les composants dont les types de composant sont employés pour équiper les cartes de circuit imprimées dans les familles d'équipement d'équipements fixes et l'élargissement de famille d'équipement respectifs ; et

- i) et exécuter l'équipement des cartes de circuit imprimées (120) des types de cartes de circuit imprimées détectés de a) sur la chaîne de production (110) au moyen de l'équipement de h).

FIG 1

## FIG 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2018177538 A1
- EP 0478361 A1